(19) Europäisches Patentamt / European Patent Office / Office européen des brevets

(11) EP 1 764 914 B1

## (12) FASCICULE DE BREVET EUROPEEN

(45) Date de publication et mention
de la délivrance du brevet:
**25.02.2009 Bulletin 2009/09**

(51) Int Cl.:
*H03F 3/45* (2006.01)

(21) Numéro de dépôt: **05291901.6**

(22) Date de dépôt: **14.09.2005**

(54) **Amplificateur différentiel sélectif à faible bruit**

Rauscharmer selektiver Differenzverstärker

Low noise selective differential amplifier

(84) Etats contractants désignés:
**AT BE BG CH CY CZ DE DK EE ES FI FR GB GR
HU IE IS IT LI LT LU LV MC NL PL PT RO SE SI
SK TR**

(43) Date de publication de la demande:
**21.03.2007 Bulletin 2007/12**

(73) Titulaire: **CSEM Centre Suisse d'Electronique et
de
Microtechnique SA Recherche et Développement
2007 Neuchâtel (CH)**

(72) Inventeur: **Chabloz, Jérémie
1020 Renens (CH)**

(74) Mandataire: **Bonnet, Michel et al
Cabinet JP COLAS
58 rue de Châteaudun
75009 Paris (FR)**

(56) Documents cités:
**EP-A- 1 548 932          US-A1- 2002 187 768
US-B1- 6 265 944**

- **GALAL S ET AL: "26.6 - 40Gb/s Amplifier and ESD
  Protection Circuit in 0.18/spl mu/m CMOS
  Technology" SOLID-STATE CIRCUITS
  CONFERENCE, 2004. DIGEST OF TECHNICAL
  PAPERS. ISSCC. 2004 IEEE INTERNATIONAL
  SAN FRANCISCO, CA, USA FEB. 15-19, 2004,
  PISCATAWAY, NJ, USA,IEEE, 15 février 2004
  (2004-02-15), pages 480-489, XP010722362 ISBN:
  0-7803-8267-6**
- **RUNGE K ET AL: "On-chip matched 5.2 and 5.8
  GHz differential LNAs fabricated using 0.35
  µm CMOS technology" ELECTRONICS
  LETTERS, IEE STEVENAGE, GB, vol. 35, no. 22,
  28 octobre 1999 (1999-10-28), pages 1899-1900,
  XP006012862 ISSN: 0013-5194**

**Description**

La présente invention concerne un amplificateur différentiel à faible bruit se distinguant des amplificateurs différentiels à faible bruit connus par le fait qu'il comporte des résonateurs à résonance série et parallèle pour le rendre sélectif en fréquence.

Un amplificateur différentiel à faible bruit connu est par exemple décrit dans la demande de brevet européen publiée sous le numéro EP 1 548 932.

Pour qu'un tel amplificateur différentiel à faible bruit puisse être utilisé dans un circuit récepteur de signal radio, il est généralement nécessaire de le disposer entre deux filtres, un premier filtre anti-bloqueurs étant disposé entre une antenne réceptrice et l'amplificateur lui-même et un second filtre à réjection d'image étant disposé en sortie de l'amplificateur.

Le premier filtre est nécessaire afin d'empêcher le circuit récepteur de saturer en présence de forts signaux perturbateurs hors bande, dits signaux bloqueurs. Le second filtre est nécessaire pour rejeter les signaux se trouvant dans la bande image, dans le cas d'un récepteur dit « hétérodyne ».

En outre, il est nécessaire de vérifier l'appariement des impédances entre l'antenne, les filtres et l'amplificateur. En effet, l'impédance de source de l'amplificateur doit impérativement correspondre à l'impédance de charge du premier filtre. De même, l'impédance de source du premier filtre doit correspondre à l'impédance de l'antenne et l'impédance de charge de l'amplificateur doit correspondre à l'impédance de source du second filtre.

Ainsi, un circuit de réception de signal radio comporte plusieurs éléments (filtres, amplificateur) dont il faut adapter les impédances de source et de charge.

L'invention vise à résoudre les problèmes liés à la complexité des circuits récepteurs existants, en fournissant un amplificateur différentiel sélectif à faible bruit ne nécessitant l'ajout ni de filtres anti-bloqueurs ou à réjection d'image en amont ou en aval, ni de circuit d'adaptation d'impédance.

L'invention a donc pour objet un amplificateur différentiel sélectif à faible bruit comportant :

- une paire de transistors, chaque transistor de cette paire étant relié par sa source à une source de courant et par sa grille et/ou sa source à une source de tension différentielle,
- un circuit de couplage entre la grille de chaque transistor et la source de l'autre transistor de la paire,

caractérisé en ce qu'il comporte en outre, pour chaque transistor de la paire, au moins un résonateur à résonance série et parallèle, disposé en série entre la source et/ou la grille de ce transistor et la source de tension différentielle.

L'association de ce type de résonateurs avec la paire de transistors de l'amplificateur différentiel à faible bruit permet d'assurer une fonction de filtrage à haut facteur de qualité et de régler en même temps l'impédance d'entrée de l'amplificateur différentiel, en jouant sur les dimensions des résonateurs.

De préférence, chaque circuit de couplage est un circuit capacitif.

De préférence également, le résonateur à résonance série et parallèle est un résonateur dont un schéma équivalent comporte un circuit RLC monté en parallèle avec un circuit capacitif. Les résonateurs piézo-électriques, et notamment les résonateurs à ondes acoustiques de volume, c'est-à-dire de type BAW (de l'anglais « Bulk - Acoustic Wave »), ont cette propriété.

Dans un mode de réalisation préféré de l'invention, l'amplificateur différentiel à faible bruit comporte, pour chaque transistor de la paire, un premier résonateur à résonance série et parallèle, disposé en série entre la grille de ce transistor et la source de tension différentielle et un second résonateur à résonance série et parallèle, disposé en série entre la source de ce transistor et la source de tension différentielle.

En particulier, pour réaliser l'adaptation d'impédance et le filtrage voulus, les premier et second résonateurs sont désaccordés en fréquence.

En outre, pour que l'amplificateur différentiel puisse remplir complètement sa fonction d'amplification en tension, les deux transistors de la paire sont reliés par leur drain respectivement à deux circuits de charge.

Avantageusement, les deux transistors de la paire sont reliés à leurs circuits de charge respectifs par l'intermédiaire de deux autres transistors montés en cascode.

De manière à améliorer la sélectivité en fréquence de l'amplificateur différentiel à faible bruit, le montage précité est relié à la source de tension différentielle par l'intermédiaire d'un circuit de préfiltrage comportant un montage en treillis symétrique à quatre branches équipé de résonateurs à résonance série et parallèle.

De préférence, chaque branche du montage en treillis du circuit de préfiltrage comporte un résonateur, deux des résonateurs de ce montage en treillis, disposés en vis-à-vis, étant conçus pour avoir la même admittance que les résonateurs raccordés en série à la grille des deux transistors de la paire, les deux autres résonateurs de ce montage en treillis, également disposés en vis-à-vis, étant conçus pour avoir la même admittance que les résonateurs raccordés en série à la source des deux transistors de la paire.

L'invention sera mieux comprise à l'aide de la description qui va suivre, donnée uniquement à titre d'exemple et faite en référence aux dessins annexés, dans lesquels :

- la figure 1 représente schématiquement la structure d'un amplificateur différentiel à faible bruit selon un mode de réalisation préféré de l'invention ;
- la figure 2 illustre un schéma équivalent d'un résonateur utilisé dans l'amplificateur de la figure 1 ;
- la figure 3 est un demi-circuit équivalent petits-signaux de modélisation d'un circuit de transconductance de l'amplificateur différentiel de la figure 1 ;
- les figures 4 et 5 sont des diagrammes indiquant les valeurs, de l'impédance de source de l'amplificateur de la figure 1, qui correspondent à l'exemple numérique du tableau n°2 ;
- la figure 6 est un diagramme représentant le module du coefficient de réflexion d'entrée du circuit de transconductance modélisé sur la figure 3, en fonction de la fréquence ;
- la figure 7 est un diagramme représentant la valeur absolue de la transconductance effective du circuit de transconductance modélisé sur la figure 3, en fonction de la fréquence ; et
- la figure 8 est un diagramme représentant le gain en tension effectif de l'amplificateur différentiel de la figure 1, en fonction de la fréquence.

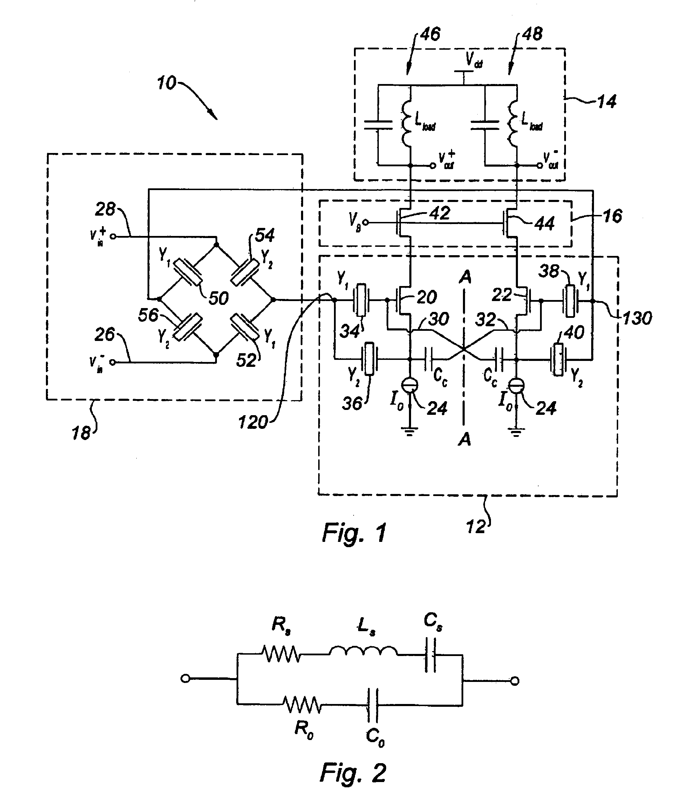

L'amplificateur différentiel à faible bruit 10 représenté sur la figure 1 comporte un circuit de transconductance 12 relié à un ensemble 14 de circuits de charge par l'intermédiaire d'un circuit en cascode 16. En outre, cet amplificateur différentiel à faible bruit 10 comporte un circuit de préfiltrage 18.

Plus précisément, dans le circuit de transconductance 12, deux transistors 20 et 22 sont reliés par leur source à deux sources de courant de polarisation $I_0$ 24 identiques et par leur grille et leur source à une source de tension différentielle comportant une source négative 26 et une source positive 28. La source de tension négative 26 a par exemple pour valeur $v_{in}^- = v_0 - \delta v$ et la source de tension positive 28 a par exemple pour valeur $v_{in}^+ = v_0 + \delta v$.

Un premier circuit de couplage 30 est disposé entre la grille du transistor 20 et la source du transistor 22. De même, un second circuit de couplage 32 est disposé entre la grille du transistor 22 et la source du transistor 20. De préférence, ces deux circuits de couplage 30 et 32 sont capacitifs, de capacité égale à $C_0$, comme indiqué sur la figure 1.

En outre, le circuit de transconductance 12 comporte un premier résonateur 34 à résonance série et parallèle, par exemple un résonateur de type BAW, d'admittance $Y_1$, disposé en série entre la grille du transistor 20 et la source de tension différentielle. Il comporte également un deuxième résonateur 36, par exemple du même type, d'admittance $Y_2$, disposé en série entre la source du transistor 20 et la source de tension différentielle. De préférence, les premier et second résonateurs 34 et 36 sont désaccordés en fréquence.

De même, un troisième résonateur BAW 38 est disposé en série entre la grille du transistor 22 et la source de tension différentielle, et un quatrième résonateur BAW 40 est disposé en série entre la source du transistor 22 et la source de tension différentielle. Par symétrie, l'admittance du troisième résonateur 38 vaut $Y_1$ et l'admittance du quatrième résonateur 40, $Y_2$. Le point commun aux résonateurs 34 et 36 constitue un premier noeud d'entrée 120 du circuit de transconductance 12 tandis que le point commun aux résonateurs 38 et 40 constitue le deuxième noeud d'entrée 130 de ce même circuit de transconductance.

On notera que les résonateurs 34, 36, 38 et 40, disposés en série sur les grilles et les sources des transistors 20 et 22 sont ainsi couplés par les deux circuits capacitifs de couplage 30 et 32 ainsi que par les transistors 20 et 22 eux-mêmes.

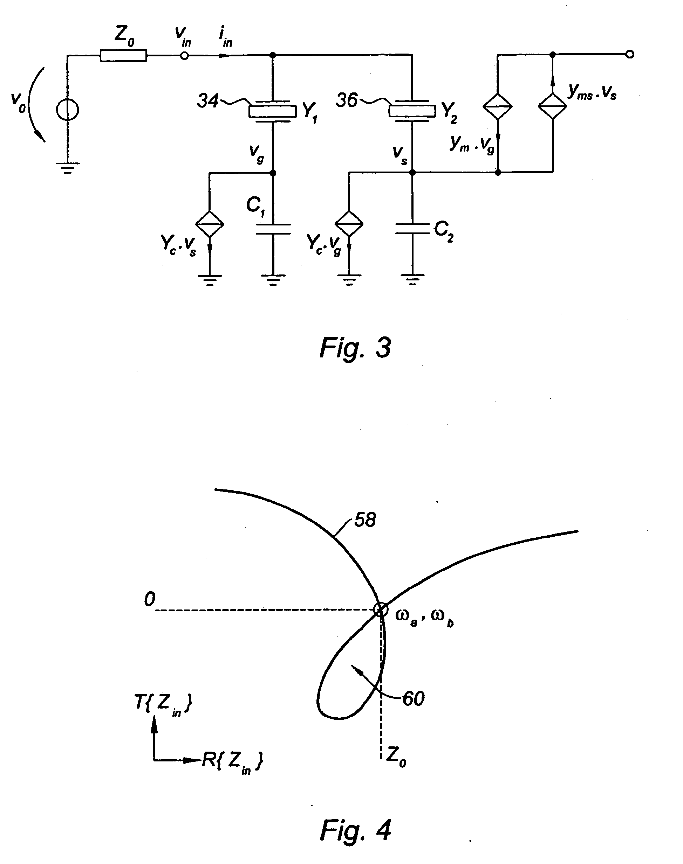

Les caractéristiques fonctionnelles des résonateurs 34, 36, 38 et 40 seront détaillées en référence à la figure 2. Quant au circuit de transconductance 12, qui présente une symétrie par rapport à l'axe A-A indiqué sur la figure 1, son fonctionnement sera décrit à l'aide du demi-circuit équivalent petits-signaux représenté sur la figure 3.

Le drain du transistor 20 est relié à un premier circuit de charge 46. De même, le drain du transistor 22 est relié à un second circuit de charge 48. De façon classique, ces deux circuits de charge 46 et 48 sont reliés entre eux et raccordés à une source de tension $V_{dd}$.

On notera que les circuits de charge 46 ou 48 sont des résonateurs parallèles LC dont la partie capacitive est assurée par des capacités parasites ainsi que par une charge capacitive. L'inductance $L_{load}$ de chacun de ces circuits permet de faire résonner la partie capacitive à une fréquence accordée sur la bande utile du signal. Le facteur de qualité des composants passifs utilisés fixe l'impédance atteinte à la résonance.

De manière à augmenter l'impédance de sortie du circuit de transconductance 12, les transistors 20 et 22 sont reliés respectivement aux circuits de charge 46 et 48 par l'intermédiaire du circuit en cascode 16 qui comporte deux autres transistors 42 et 44 montés en cascode, leur grille étant raccordée à une tension commune $V_B$. Chaque transistor 42 ou 44 est relié au drain de l'un des transistors 20 ou 22 et relié au circuit de charge correspondant 46 ou 48.

Le circuit en cascode 16 permet également de limiter l'effet de la capacité Miller sur la stabilité globale de l'amplificateur différentiel à faible bruit 10.

Le circuit de préfiltrage 18 est disposé entre les noeuds d'entrée 120 et 130 du circuit de transconductance 12 et la source de tension différentielle 26, 28.

Il comporte un montage en treillis symétrique à quatre branches équipé de résonateurs 50, 52, 54 et 56, par exemple de type BAW. De façon judicieuse, les résonateurs 50 et 52, disposés en vis-à-vis dans le montage en treillis, sont choisis pour avoir la même admittance $Y_1$ que les résonateurs 34 et 38. Les résonateurs 54 et 56, également disposés en vis-à-vis dans le montage en treillis, sont eux choisis pour avoir la même admittance $Y_2$ que les résonateurs 36 et 40.

L'ajout de ce circuit de préfiltrage 18 permet d'améliorer la sélectivité en fréquence de l'amplificateur différentiel à faible bruit 10.

Un circuit équivalent au premier ordre des résonateurs 34, 36, 38, 40, 50, 52, 54 et 56 utilisés dans l'amplificateur différentiel à faible bruit 10 est illustré sur la figure 2.

Il comporte un circuit RLC comprenant une résistance $R_s$, une inductance $L_s$ et une capacité $C_s$, monté en parallèle avec un circuit capacitif comprenant une résistance $R_0$ et une capacité $C_0$.

Ainsi, l'admittance $y$ normalisée à $Y_0$ d'un résonateur dont la fréquence de résonance série vaut $\omega_s = k\,\omega_0$ est exprimée par l'équation suivante :

$$y = \frac{Y}{Y_0} = k \cdot \frac{\rho\,Q}{1 + jQ\,x_k} + \frac{j\,\Omega}{1 + j\,\Omega\tan(\delta)/k} , \qquad (1)$$

dans laquelle $x_k$ est le désaccord défini par l'équation suivante :

$$x_k = \frac{\Omega}{k} - \frac{k}{\Omega} . \qquad (2)$$

Dans l'équation (1), $\rho$ est un facteur technologique qui représente le couplage piézo-électrique et Q est le facteur de qualité de la résonance série du résonateur dont le circuit équivalent est représenté sur la figure 2. Le facteur $\tan(\delta)$ est le facteur de pertes de la capacité diélectrique, tel que $R_0\,Y_0 = \tan(\delta)/k$.

Enfin, les grandeurs de normalisation utilisées dans l'équation 1 sont données par le tableau suivant :

TABLEAU n°1 - Grandeurs de normalisation

| Grandeur | Normalisation | |
|---|---|---|
| Fréquence | $\Omega = \omega/\omega_0$ | $\Omega_s = \omega_s/\omega_0 = k$ |
| Admittance | $y = Y/Y_0$ | $Y_0 = \omega_0 \cdot C_0$ |
| Impédance | $z = Z \cdot Y_0$ | |
| Capacité | $c = C/C_0$ | |

L'équation (1) peut se simplifier de la façon suivante :

$$y \approx k \cdot \frac{\rho\,Q}{1 + jQ\,x_k} + j\,\Omega, \ \text{lorsque} \ \ \Omega \ll \frac{k}{\tan(\delta)} . \qquad (3)$$

On notera que le principe de fonctionnement même du résonateur décrit ici est indépendant de la technique utilisée pour sa réalisation. Il devrait donc pouvoir être mis en oeuvre avec n'importe quel type de résonateur dont le schéma équivalent correspond à celui de la figure 2.

Dans le circuit de la figure 1, les résonateurs 34, 38, 50 et 52 d'admittance $Y_1$ ont une fréquence de résonance série égale à $\omega_{1s} = k_{1s}\,\omega_0$, alors que les résonateurs 36, 40, 54 et 56 d'admittance $Y_2$ ont une fréquence de résonance série différente égale à $\omega_{2s} = k_{2s}\,\omega_0$. Le rapport $k_{2s}/k_{1s}$ exprime le désaccord en fréquence des résonateurs d'admittance $Y_2$ par rapport aux résonateurs d'admittance $Y_1$.

Le circuit de transconductance 12 fonctionne en mode différentiel et est exactement symétrique. Son demi-circuit équivalent petits-signaux est représenté sur la figure 3.

Ce demi-circuit équivalent permet de calculer les différentes performances de l'amplificateur à faible bruit. Les grandeurs $C_1$, $C_2$ et $Y_c$ utilisées sur la figure 3 sont définies par les équations suivantes :

$$C_1 = C_c + C_{gs},\tag{4}$$

$$C_2 = C_c + C_{gs},\tag{5}$$

$$Y_c = j\omega \cdot (C_c - C_{gs}),\tag{6}$$

où $C_{gs}$ représente la capacité parasite du transistor 20 ou 22 entre sa source et sa grille

En outre, $y_m$ et $y_{ms}$ représentent des paramètres de transconductance de sources de courant commandées en tension.

Il est nécessaire que l'impédance d'entrée notée $Z_{in}$ de l'amplificateur différentiel à faible bruit soit adaptée à l'impédance notée $Z_0$ de l'antenne du circuit récepteur de signal radio pour que le transfert de puissance soit optimal. Cette condition se traduit mathématiquement par l'équation suivante :

$$Z_0 = Z_{in}^*.\tag{7}$$

A partir du demi-circuit équivalent petits-signaux, il devient facile de calculer l'impédance d'entrée que doit avoir l'amplificateur différentiel à faible bruit :

$$Y_{in} = \frac{1}{Z_{in}} = H_1 \cdot Y_1 + H_2 \cdot Y_2,\tag{8}$$

Où $H_1$ est définie par :

$$H_1 = 1 - \frac{v_g}{v_{in}},\tag{9}$$

Et $H_2$ par:

$$H_2 = 1 - \frac{v_s}{v_{in}}.\tag{10}$$

Les fonctions auxiliaires $H_1$ et $H_2$ sont calculées en fonction des grandeurs du demi-circuit équivalent petits-signaux et données par les équations suivantes dans lesquelles $s = j\omega$ :

$$H_1 = 1 - \left( Y_2 - \frac{Y_1}{Y_c} \cdot (sC_2 + Y_2 + y_{ms}) \right) \cdot \frac{1}{D},\tag{11}$$

$$H_2 = 1 - \left( (Y_c - y_m) \cdot \frac{Y_1}{Y_c} - \frac{sC_1 + Y_1}{Y_c} \cdot Y_2 \right) \cdot \frac{1}{D},\tag{12}$$

avec

$$D = Y_c - y_m - \left(s\,C_2 + Y_2 + y_{ms}\right) \cdot \frac{s\,C_1 + Y_1}{Y_c}. \qquad (13)$$

D'après ces équations (dans lesquelles la capacité Miller a été négligée, ce qui est en partie justifié par la présence du circuit en cascode 16 relié au circuit de transconductance 12 qui permet de limiter l'effet de cette capacité Miller), le lieu complexe de l'impédance d'entrée $Z_{in}$ de l'amplificateur différentiel à faible bruit 10, au voisinage des fréquences de résonance série et parallèle des résonateurs 34, 36, 38 et 40, possède l'allure générale donnée par le diagramme de la figure 4. Ce lieu complexe est représenté par la courbe 58.

Sur cette courbe, on remarque qu'il existe deux fréquences $\omega_a$ et $\omega_b$, comprises entre la résonance série des résonateurs 34 et 38 et la résonance parallèle des résonateurs 36 et 40, pour lesquelles l'impédance d'entrée est la même. On remarque aussi, de façon empirique, qu'il est possible d'annuler complètement la partie imaginaire de cette impédance d'entrée par un choix judicieux de la capacité $C_c$ des circuits de couplage 30 et 32.

Ainsi, par un réglage adéquat des dimensions des résonateurs, il est possible d'adapter parfaitement l'amplificateur différentiel 10 à une impédance réelle $Z_0$ (celle de l'antenne) en ces deux fréquences différentes $\omega_a$ et $\omega_b$. Entre ces deux fréquences, la valeur de l'impédance d'entrée de l'amplificateur différentiel 10 varie peu dans un voisinage 60 du point $(Z_0, 0)$ dans le plan complexe, comme cela est représenté par la boucle formée par la courbe 58 dans ce voisinage 60.

Un exemple numérique est donné ci-dessous. Les valeurs normalisées selon le tableau 1 sont reprises dans le tableau 2 suivant :

TABLEAU n°2 - Valeurs normalisées pour l'exemple numérique

| | | |
|---|---|---|
| Facteur de qualité | $Q$ | 600 |
| Facteur de couplage | $\rho$ | 0,054 |
| Facteur de perte diélectrique | $\tan(\delta)$ | 0,07 |
| Transconductance | $y_{ms}/Y_0$ | 0,7 |
| Capacité grille-source | $C_{gs}/C_0$ | $60 \cdot 10^{-3}$ |
| Facteur de désaccord entre $Y_1$ et $Y_2$ | $k_{2s}/k_{1s}$ | 1,025 |
| Capacité de couplage | $C_c/C_0$ | 8,8925 |
| Fréquences d'adaptation | $\Omega_a = \omega_a/\omega_0$ <br> $\Omega_b = \omega_b/\omega_0$ | 1,0249 <br> 1,0358 |
| Impédance d'entrée | $Z_{in}(\omega_a, \omega_b) \cdot Y_0 = Z_0 \cdot Y_0$ | 0,6258 + 0j |

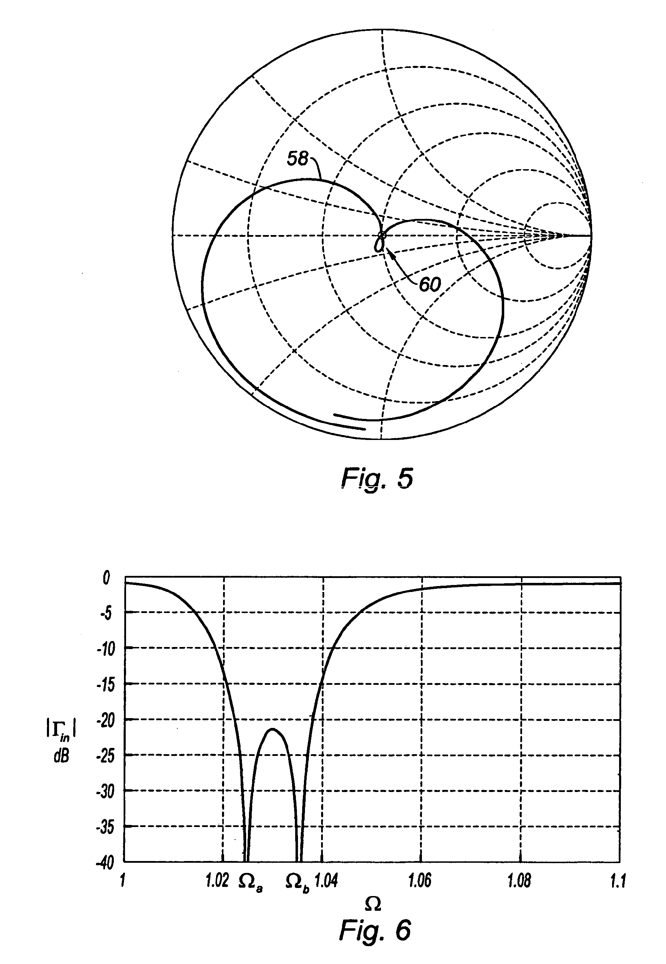

Une autre représentation de la courbe 58, à l'aide de l'abaque de Smith de la figure 5, pour $\Omega$ compris entre 0,8 et 1,2 et pour les valeur numériques données dans le tableau n°2, montre clairement la quasi constance de l'impédance d'entrée $Z_{in}$ de l'amplificateur différentiel 10 entre $\omega_a$ et $\omega_b$ et, d'une façon plus générale, la stabilité du lieu complexe de $Z_{in}$, puisque la courbe 58 reste dans le cercle unité de l'abaque de Smith autour du point $(Z_0, 0)$.

Il est également possible de représenter l'adaptation d'impédance en fonction de $\Omega$ par le paramètre $\Gamma_{in}$, défini par la relation suivante :

$$\Gamma_{in} = \frac{Z_{in} - Z_0}{Z_{in} + Z_0}. \qquad (14)$$

$\Gamma_{in}$ est le coefficient de réflexion d'entrée défini par rapport à l'impédance $Z_0$ de l'antenne. Pour les valeurs numériques du tableau 2, l'évolution de ce coefficient est représentée sur le diagramme de la figure 6. On notera que les deux valeurs $\omega_a$ et $\omega_b$ d'adaptation décalées en fréquence permettent une adaptation raisonnable sur une bande de fréquence d'environ 2%.

Par ailleurs, pour mesurer le gain de l'amplificateur différentiel à faible bruit 10 indépendamment des circuits de charge, il est intéressant de représenter la transconductance effective $g_{eff}$ qui est donnée par la relation suivante :

$$g_{eff} = \frac{i_{out}}{v_0} = \frac{i_{out}}{v_{in}} \cdot \frac{1}{1 + y_{in} z_0}, \qquad (15)$$

avec

$$\frac{i_{out}}{v_{in}} = y_m \cdot \frac{v_g}{v_{in}} - y_{ms} \cdot \frac{v_s}{v_{in}} = \frac{y_{ms}}{n} \cdot (1 - H_1) - y_{ms} \cdot (1 - H_2). \qquad (16)$$

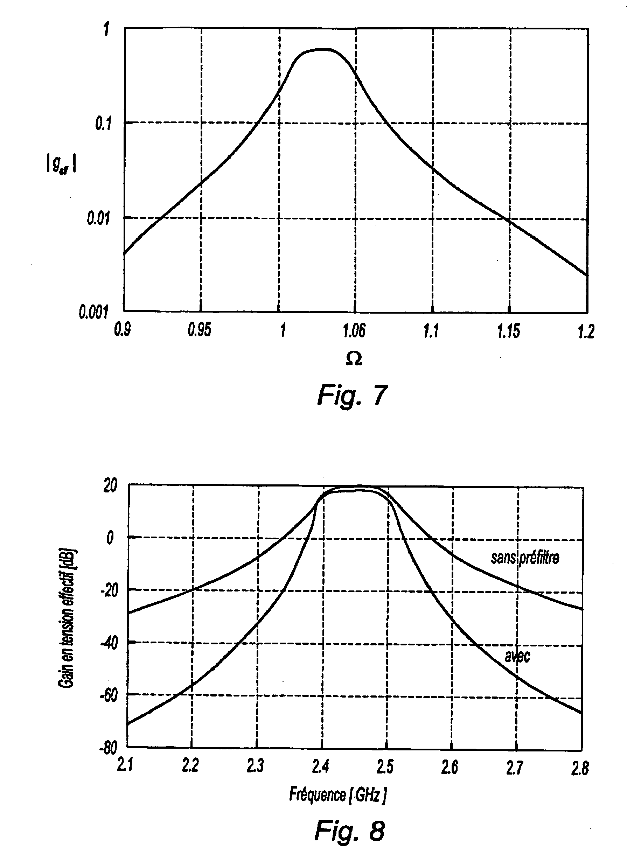

En reprenant les valeurs numériques du tableau n°2, on obtient le diagramme de la figure 7.

On remarque notamment, en comparant les figures 6 et 7, que la bande passante de la transconductance effective $g_{eff}$ correspond à la bande de fréquence $[\omega_a, \omega_b]$ dans laquelle l'adaptation d'impédance est réalisée.

Enfin, la figure 8 illustre l'amélioration apportée par la présence du circuit de préfiltrage 18 dans l'amplificateur différentiel 10. Les signaux sont davantage atténués en dehors de la bande passante $[\omega_a, \omega_b]$. La sélectivité est donc sensiblement meilleure.

Il apparaît clairement qu'un amplificateur différentiel à faible bruit tel que décrit précédemment permet de réaliser une fonction d'amplification combinée à un filtrage très sélectif des signaux radiofréquence reçus par l'antenne du circuit récepteur.

Un tel amplificateur ne nécessite pas l'ajout d'autres composants passifs supplémentaires à ceux déjà utilisés pour réaliser le filtrage. Notamment aucun filtre antibloqueur ou à réjection d'image n'est nécessaire.

## Revendications

1. Amplificateur différentiel sélectif à faible bruit (10) comportant :

    - une paire de transistors (20, 22), chaque transistor de cette paire étant relié par sa source à une source de courant (24) et par sa grille et/ou sa source à une source de tension différentielle (26, 28),
    - un circuit de couplage (30, 32) entre la grille de chaque transistor et la source de l'autre transistor de la paire,

    **caractérisé en ce qu'**il comporte en outre, pour chaque transistor de la paire, au moins un résonateur à résonance série et parallèle (34, 36, 38, 40), disposé en série entre la source et/ou la grille de ce transistor et la source de tension différentielle.

2. Amplificateur différentiel à faible bruit (10) selon la revendication 1, dans lequel chaque circuit de couplage (30, 32) est un circuit capacitif.

3. Amplificateur différentiel à faible bruit (10) selon la revendication 1 ou 2, dans lequel le résonateur à résonance série et parallèle (34, 36, 38, 40) est un résonateur dont un schéma équivalent comporte un circuit RLC série monté en parallèle avec un circuit capacitif.

4. Amplificateur différentiel à faible bruit (10) selon l'une quelconque des revendications 1 à 3, dans lequel le résonateur à résonance série et parallèle (34, 36, 38, 40) est un résonateur piézoélectrique, notamment un résonateur à ondes acoustiques de volume.

5. Amplificateur différentiel à faible bruit (10) selon l'une quelconque des revendications 1 à 4, comportant, pour chaque transistor (20, 22) de la paire, un premier résonateur à résonance série et parallèle (34, 38), disposé en série entre la grille de ce transistor et la source de tension différentielle (26, 28) et un second résonateur à résonance série et parallèle (36, 40), disposé en série entre la source de ce transistor et la source de tension différentielle.

6. Amplificateur différentiel à faible bruit (10) selon la revendication 5, dans lequel les premier (34, 38) et second (36, 40) résonateurs sont désaccordés en fréquence.

7. Amplificateur différentiel à faible bruit (10) selon l'une quelconque des revendications 1 à 6, dans lequel les deux transistors (20, 22) de la paire sont reliés par leur drain respectivement à deux circuits de charge (46, 48).

**8.** Amplificateur différentiel à faible bruit (10) selon la revendication 7, dans lequel les deux transistors (20, 22) de la paire sont reliés à leurs circuits de charges (46, 48) respectifs par l'intermédiaire de deux autres transistors (42, 44) montés en cascode.

**9.** Amplificateur différentiel à faible bruit (10) selon l'une quelconque des revendications 1 à 8, dans lequel les deux transistors (20, 22) de la paire sont reliés par leur grille et leur source à la source de tension différentielle (26, 28) par l'intermédiaire d'un circuit de préfiltrage (18) comportant un montage en treillis symétrique à quatre branches équipé de résonateurs à résonance série et parallèle (50, 52, 54, 56).

**10.** Amplificateur différentiel à faible bruit (10) selon la revendication 9, dans lequel chaque branche du montage en treillis du circuit de préfiltrage comporte un résonateur, deux des résonateurs de ce montage en treillis, disposés en vis-à-vis, étant conçus pour avoir la même admittance que les résonateurs (34, 38) raccordés en série à la grille des deux transistors (20, 22) de la paire, les deux autres résonateurs de ce montage en treillis, également disposés en vis-à-vis, étant conçus pour avoir la même admittance que les résonateurs (36, 40) raccordés en série à la source des deux transistors (20, 22) de la paire.

**Claims**

**1.** Selective differential low-noise amplifier (10) comprising:

- a pair of transistors (20, 22), each transistor of said pair being connected by its source to a current source (24) and by its gate and/or its source to a differential voltage source (26, 28),
- a coupling circuit (30, 32) between the gate of each transistor and the source of the other transistor of the pair,

**characterised in that** it further comprises, for each transistor of the pair, at least one series resonance and parallel resonance resonator (34, 36, 38, 40) connected in series between the source and/or the gate of said transistor and the differential voltage source.

**2.** Differential low-noise amplifier (10) according to claim 1, wherein each coupling circuit (30, 32) is a capacitive circuit.

**3.** Differential low-noise amplifier (10) according to either claim 1 or claim 2, wherein the series resonance and parallel resonance resonator (34, 36, 38, 40) is a resonator, of which an equivalent circuit comprises a series RLC circuit connected in parallel with a capacitive circuit.

**4.** Differential low-noise amplifier (10) according to any one of claims 1 to 3, wherein the series resonance and parallel resonance resonator (34, 36, 38, 40) is a piezoelectric resonator, in particular a bulk acoustic wave resonator.

**5.** Differential low-noise amplifier (10) according to any one of claims 1 to 4, comprising, for each transistor (20, 22) of the pair, a first series resonance and parallel resonance resonator (34, 36, 38, 40) connected in series between the gate of said transistor and the differential voltage source (26, 28) and a second series resonance and parallel resonance resonator (36, 40) connected in series between the source of said transistor and the differential voltage source.

**6.** Differential low-noise amplifier (10) according to claim 5, wherein the first resonator (34, 38) and said second resonator (36, 40) are detuned.

**7.** Differential low-noise amplifier (10) according to any one of claims 1 to 6, wherein the two transistors (20, 22) of the pair are connected by their drain to two respective load circuits (46, 48).

**8.** Differential low-noise amplifier (10) according to claim 7, wherein the two transistors (20, 22) of the pair are connected to their respective load circuits (46, 48) via two other transistors (42, 44) in a cascode configuration.

**9.** Differential low-noise amplifier (10) according to any one of claims 1 to 8, wherein the two transistors (20, 22) of the pair are connected by their gate and their source to the differential voltage source (26, 28) via a prefilter circuit (18) comprising a symmetrical lattice circuit with four branches equipped with series resonance and parallel resonance resonators (50, 52, 54, 56).

10. Differential low-noise amplifier (10) according to claim 9, wherein each branch of the lattice circuit of the prefilter circuit comprises a resonator, two of the resonators of said lattice circuit being arranged face-to-face and configured so as to have the same admittance as the resonators (34, 38) connected in series to the gate of the two transistors (20, 22) of the pair, the other two resonators of this lattice circuit also being arranged face-to-face and configured so as to have the same admittance as the resonators (36, 40) connected in series to the source of the two transistors (20, 22) of the pair.


**Patentansprüche**

1. Rauscharmer selektiver Differentialverstärker (10) mit:

   - einem Paar Transistoren (20, 22), wobei jeder Transistor des Paares mit seiner Source an eine Stromquelle (24) und mit seinem Gate an eine Differentialspannungsquelle (26, 28) angeschlossen ist,
   - einer Verbindungsschaltung (30, 32) zwischen dem Gate jedes Transistors und der Source des anderen Transistors des Paares,

   **dadurch gekennzeichnet, dass** er ferner für jeden Transistor des Paares einen Resonator (34, 36, 38, 40) mit serieller und paralleler Resonanz aufweist, der in Reihe zwischen der Source und/oder dem Gate dieses Transistors und der Differentialspannungsquelle angeordnet ist.

2. Rauscharmer Differentialverstärker (10) nach Anspruch 1, bei welchem jede Verbindungsschaltung (30, 32) eine kapazitive Schaltung ist.

3. Rauscharmer Differentialverstärker (10) nach Anspruch 1 oder 2, bei welchem der Resonator (34, 36, 38, 40) mit serieller und paralleler Resonanz ein Resonator ist, dessen Ersatzschaltbild eine RLC-Serienschaltung aufweist, die parallel zu einer kapazitiven Schaltung montiert ist.

4. Rauscharmer Differentialverstärker (10) nach einem der Ansprüche 1 bis 3, bei welchem der Resonator (34, 36, 38, 40) mit serieller und paralleler Resonanz ein piezoelektrischer Resonator, insbesondere ein mit akustischen Volumenwellen arbeitender Resonator, ist.

5. Rauscharmer Differentialverstärker (10) nach einem der Ansprüche 1 bis 4, der für jeden Transistor (20, 22) des Paares einen ersten Resonator (34, 38) mit serieller und paralleler Resonanz, der in Reihe zwischen dem Gate dieses Transistors und der Differentialspannungsquelle (26, 28) angeordnet ist, und einen zweiten Resonator (36, 40) mit serieller und paralleler Resonanz aufweist, der in Reihe zwischen der Source dieses Transistors und der Differentialspannungsquelle angeordnet ist.

6. Rauscharmer Differentialverstärker (10) nach Anspruch 5, bei welchem die ersten (34, 38) und die zweiten (36, 40) Resonatoren nicht in der Frequenz abgestimmt sind.

7. Rauscharmer Differentialverstärker (10) nach einem der Ansprüche 1 bis 6, bei welchem die beiden Transistoren (20, 22) des Paares über ihren Drain jeweils mit zwei Lastschaltungen (46, 48) verbunden sind.

8. Rauscharmer Differentialverstärker (10) nach Anspruch 7, bei welchem die beiden Transistoren (20, 22) des Paares mit ihren jeweiligen Lastschaltungen (46, 48) über zwei andere, in Kaskade angebrachte Transistoren (42, 44) verbunden sind.

9. Rauscharmer Differentialverstärker (10) nach einem der Ansprüche 1 bis 8, bei welchem die beiden Transistoren (20, 22) des Paares mit ihrem Gate und ihrer Source über eine Vorfilterschaltung (18) mit der Differentialspannungsquelle (26, 28) verbunden sind, wobei die Vorfilterschaltung eine symmetrische Gitterstruktur mit vier Zweigen aufweist, welche mit Resonatoren (50, 52, 54, 56) mit serieller und paralleler Resonanz versehen sind.

10. Rauscharmer Differentialverstärker (10) nach Anspruch 9, bei welchem jeder Zweig der Gitterstruktur der Vorfilterschaltung einen Resonator aufweist, wobei zwei der Resonatoren der Gitterstruktur, welche einander gegenüberliegen, derart ausgebildet sind, dass sie die gleiche Admittanz wie die Resonatoren (34, 38) aufweisen, die in Reihe mit dem Gate der beiden Transistoren (20, 22) des Paares verbunden sind, wobei die beiden anderen Resonatoren der Gitterstruktur, die ebenfalls einander gegenüberliegend angeordnet sind, derart ausgebildet sind, dass sie die gleiche Admittanz wie die Resonatoren (36, 40) aufweisen, die in Reihe mit der Source der beiden Transistoren (20, 22) des Paares verbunden sind.

Fig. 1

Fig. 2

Fig. 3

Fig. 4

Fig. 5

Fig. 6

Fig. 7

Fig. 8

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1548932 A